# EUROPEAN PATENT APPLICATION

(11) **EP 4 789 896 A1**
(43) Date of publication of application: **12.08.2026**
(21) Application number: 25156292.2
(22) Date of filing: 06.02.2025
(51) Int. Cl.: B60L 3/00, B60L 1/00, B60L 3/12, B60L 58/10, H02J 7/00, B60L 58/16, G01R 31/392, G06N 5/01, G06N 20/00, G06N 20/20, G05B 13/02, G05B 13/04, G05B 23/02

(54) **METHOD FOR TRAINING A DATA MODEL FOR DETECTING AN ANOMALY IN A TRACTION BATTERY PACK OF A VEHICLE, AND METHODS FOR DETECTING AND HANDLING AN ANOMALY IN A TRACTION BATTERY PACK OF A VEHICLE**

(71) Applicant: Volvo Car Corporation, 405 31 Göteborg (SE)
(72) Inventor: NGU, Johnny, 40531 Göteborg (SE); HANSSON, Fredrik, 40531 Göteborg (SE)
(74) Representative: Kransell & Wennborg KB

(57) **Abstract**

The disclosure relates to a method for training a data model (56) for detecting an anomaly in a traction battery pack (14) of a vehicle (12). The method comprises obtaining first data (D1) indicative of at least one state parameter of the traction battery pack (14) and second data (D2) indicative of a usage history statistic of the traction battery pack (14). The first data (D1) and the second data (D2) relate to a plurality of traction battery packs (14) of vehicles (12) out of a group (64) of vehicles (12). The first data (D2) and the second data (D2) are labelled with labelling data indicative of a presence or absence of an anomaly of the associated traction battery pack (14). The method further comprises training the data model (56) based on the labelled first data (D1) and the labelled second data (D2). The disclosure further relates to a method for detecting an anomaly in a traction battery pack (14) of a vehicle (12). Moreover, the disclosure is directed to a method for handling an anomaly in a traction battery pack (14) of a vehicle (12).

## Description

### TECHNICAL FIELD

The present disclosure relates to a method for training a data model for detecting an anomaly in a traction battery pack of a vehicle.

Moreover, the present disclosure relates to a method for detecting an anomaly in a traction battery pack of a vehicle.

Furthermore, the present disclosure relates to a method for handling an anomaly in a traction battery pack of a vehicle.

### BACKGROUND ART

Traction battery packs of electric vehicles may exhibit anomalies such as aging of battery cells of the traction battery pack that goes quicker than expected, temperature increases and/or damages to structural parts of the traction battery pack during use of an electric vehicle.

If such anomalies are detected early, further damage to the traction battery pack or even to the entire electric vehicle may be avoided or at least mitigated by performing a targeted maintenance action.

However, users of electric vehicles may often not be aware of the traction battery of their vehicle being subject to an anomaly.

### SUMMARY

Hence, there may be a need for improved anomaly detection for traction battery packs of electric vehicles.

The problem is at least partially solved or alleviated by the subject matter of the independent claims of the present disclosure, wherein further examples are incorporated in the dependent claims.

According to a first aspect, there is provided a method for training a data model for detecting an anomaly in a traction battery pack of a vehicle. The method comprises obtaining first data indicative of at least one state parameter of the traction battery pack and second data indicative of a usage history statistic of the traction battery pack. The first data and the second data relate to a plurality of traction battery packs of vehicles out of a group of vehicles. Moreover, the first data and the second data are labelled with labelling data indicative of a presence or absence of an anomaly of the associated traction battery pack. The method further comprises training the data model based on the labelled first data and the labelled second data.

An anomaly in a traction battery pack may be understood as a deviation from a norm and/or from an expected state of the traction battery pack. This may affect a performance of the traction battery pack, e.g. an electric performance. A data model is understood as a representation or at least as an approximation of data structures or data patterns in a decision or prediction function. Obtaining the first data and the second data is to be understood as receiving or determining the first data and the second data. The first data indicative of at least one state parameter of the traction battery pack characterizes a state of the traction battery pack, i.e. a property associated with a point in time. The first data can be imagined as a snapshot of a state of the traction battery pack taken at a specific point in time. The first data does not comprise any aggregation or clustering of data over time. Still, the first data may comprise not only one but a plurality of data items relating to a specific point in time. The plurality of data items may relate to different state parameters of the traction battery pack at a specific point in time and/or to the same state parameter of the traction battery pack at different points in time. It is noted that the time of determining the first data does not necessarily have to be the same as the time of receiving the first data, especially in a case in which obtaining the first data is understood as receiving the first data. The second data indicative of a usage history statistic of the traction battery pack comprises an aggregation and/or processing of a plurality of characterizations of historic states of the traction battery pack. Historic states of the traction battery pack are understood as a plurality of states that the traction battery pack has assumed prior to the determination of the second data or up to the determination of the second data. This means that historic states are states from a past time. The aggregation and/or processing of a plurality of characterizations of historic states of the traction battery pack may for example comprise an accumulation, an averaging and/or a normalization of traction battery pack state parameters from a plurality of points in time.

The first data and the second data are obtained from the same vehicles, i.e. the same traction battery packs, out of the group of vehicles. The group of vehicles may e.g. be what generally is referred to as a vehicle fleet, or may e.g. be defined by that the vehicles of the group of vehicles share the same electrified propulsion or battery platform, are of one or more particular vehicle models or are produced by the one or more car manufacturers.

The first data and the second data being labelled with labeling data indicative of a presence or absence of an anomaly of the associated traction battery pack is to be understood in that both the first data and the second data comprise annotations indicative of a presence or absence of an anomaly of the traction battery pack of the vehicle of the group of vehicles that the first data and the second data correspond to. In one example, an execution of the method may comprise labeling the first data and the second data with the labeling data. In another example, an execution of the method may comprise obtaining labelled first data and labelled second data. In any case, the data model is trained based on the labelled first data and based on the labelled second data so that the data model may learn structures and/or patterns in the first data and in the second data that allow a decision and/or prediction of if a traction battery pack is subject to an anomaly based on its first data and based on its second data. Thus, the labelled first data and the labelled second data may also be referred to as training data. Having the data model trained on first data indicative of at least one state parameter of the traction battery pack and on second data indicative of a usage history statistic of the traction battery pack improves a decision and/or prediction accuracy of the data model at inference, hence when it is being used to decide on and/or predict an anomaly of an unknown traction battery pack. Moreover, particularly the second data indicative of the usage history statistic of the traction battery pack comprising an aggregation and/or processing of a plurality of characterizations of historic states of the traction battery pack reduces an amount of parameters to be considered during training of the data model. Thus, training speed is increased while at the same time not losing information on a usage history of the traction battery pack.

In an example, the data model comprises a supervised learning model. In supervised learning and for the sake of training, the data model may be made to make predictions on whether traction battery packs corresponding to at least parts of the labelled first data and to at least parts of the labelled second data exhibit an anomaly. The predictions of the data model during training may be compared to the actual labels provided to the first data and to the second data in order to iteratively reduce an overall prediction error between anomaly predictions and actual occurrences of anomalies among the traction battery packs of the vehicles of the group of vehicles. Having the data model trained on verified labels for the first data and for the second data has the effect that a predictability, i.e. an explainability, of an outcome, i.e. a result, of the data model when applied to unknown first data and unknown second data is enhanced. In particular, it is ensured that the data model does not recognize any arbitrary patterns in the first data and/or in the second data that do not have anything to do with the objective of creating a data model that is capable of detecting anomalous traction battery packs in electric vehicles.

In an example, the data model comprises a decision tree model. A decision tree model comprises decision nodes at which the decision tree model branches into two alternatives. A decision function created at a decision node of a decision tree model comprises an algebraic comparison between an input to the decision node and a decision value of the decision node. The decision value may relate either to the first data or to the second data or to both. A decision tree model comes with the advantage that a human developer may well interpret a decision node and a corresponding decision value created by machine learning. It is understood that the decision tree model may comprise several levels of consecutive decision nodes. At the end of a decision branch, there is a so-called leaf node indicating a decision and/or prediction of the decision tree. In the present case, the decision and/or prediction of the decision tree is an indication if the traction battery pack exhibits an anomaly or if it functions properly. Using a decision tree model is an efficient way of classifying traction battery packs of vehicles into anomalous traction battery packs or properly functioning traction battery packs. In this context, efficient may mean a reduced training effort, e.g. reduced amount of training data and/or reduced model complexity requiring less computational resources for training, and/or a high accuracy of decision and/or prediction results of the decision tree model compared to other machine learning data models.

In an example, the data model comprises an ensemble learning model. An ensemble learning model is a type of machine learning model that makes use of a plurality of learning models. The plurality of learning models are aggregated and/or combined in order to achieve an output and/or a result of the ensemble learning model. This has the effect that an aggregated and/or a combined output of the plurality of learning models is more accurate than an output of any of the individual learning models of the plurality of learning models. Moreover, due to the fact that a plurality of learning models is trained on subsets of the training data, a tendency of an ensemble learning model towards overfitting to the training data is reduced compared to other machine learning models, and model diversity is enhanced. This may be of particular relevance in case there is a limited amount of training data available or in case there is limited amount of training data on at least one decision and/or prediction alternative of the data model available, e.g. limited training data that is annotated with a specific label.

In an example, the data model comprises a random forest classification model. A random forest classification model uses a plurality of decision trees for making a decision and/or a prediction on input data regarding a particular feature corresponding to the input data, e.g. by means of majority voting. Thus, a random forest classification model is an ensemble learning model that comprises a plurality of decision trees. In the present case, the plurality of decision trees are trained on subsets of the labelled first data and on the labelled second data. For training of the plurality of decision trees, training data sets for training each individual decision tree may for example be obtained from the labelled first data and from the labelled second data by bootstrap aggregating, i.e. by duplicating certain data items of the labelled first data and corresponding data items of the labelled second data while deleting other data items of the labelled first data and corresponding data items of the labelled second data. This has the effect that a variability among the plurality of trained decision trees is increased. In other words, it is avoided that a plurality of all too similar decision trees is created by a training process. This preserves an ability of the random forest data model to generalize, i.e. to make accurate decisions and/or predictions on unknown input data of the same type as the training data, i.e. of the type of the first data and of the second data. A decision and/or a prediction output of the random forest classification model may be obtained from a majority vote of decision and/or prediction outputs of the individual decision trees of the random forest classification model. In the present case, the decision and/or the prediction output of the random forest classification model is indicative of an investigated traction battery pack exhibiting an anomaly or functioning properly. Thus, an efficient and accurate classifier for determining whether a traction battery pack of the vehicle is subject to an anomaly or not may be trained.

In an example, the first data is indicative of at least one of:
- a deviation of a state of charge per subset of battery cells of the traction battery pack from a first statistical parameter, the first statistical parameter being descriptive of a collective state of charge for a set of battery cells to which the subset belongs,
- a deviation of a state of health per subset of battery cells of the traction battery pack from a second statistical parameter, the second statistical parameter being descriptive of a collective state of health for a set of battery cells to which the subset belongs, and
- a statistical distance measure per subset of battery cells of the traction battery pack based on the deviation of the state of charge and the deviation of the state of health.

Usually, the traction battery pack comprises a plurality of battery cells. This plurality of battery cells may be subdivided in sets and subsets. A subset of battery cells may therefore be understood as a portion of the battery cells of a set of battery cells. The set of battery cells may comprise all battery cells of the traction battery pack or all battery cells of a module, i.e. a sub-unit, of the traction battery pack. The subset of battery cells may comprise at least one battery cell. The collective state of charge for the set of battery cells is to be understood as a state of charge characterizing the set of battery cells, i.e. a plurality of battery cells. Thus, the first data is indicative of a deviation and/or a difference of the state of charge of a subset of battery cells, e.g. an individual battery cell, with respect to the state of charge of the set of battery cells. Likewise, the collective state of health for the set of battery cells is to be understood as a state of health characterizing the set of battery cells, i.e. a plurality of battery cells. Thus, the first data is also indicative of a deviation and/or a difference of the state of health of a subset of battery cells, e.g. an individual battery cell, with respect to the state of health of the set of battery cells. The statistical distance measure expresses the deviation and/or the difference of the state of charge of the subset, e.g. the individual battery cell, as well as the deviation and/or the difference of the state of health of the subset, e.g. the individual battery cell, with respect to the state of charge and the overall state of health of the set of battery cells, respectively. This means that both the state of charge and the state of health of the subset, e.g. the individual battery cells, are considered when obtaining the statistical distance measure. Considering the state of charge and the state of health and using a collective state of charge and a collective state of health allows a particularly accurate identification of anomalous battery cells.

In an example, the statistical distance measure is configured to account for statistical covariance between the deviation in state of charge and the deviation in state of health. In an example, the statistical distance measure is a statistical covariance measure. The statistical covariance is a measure of the joint variability of the deviation in state of charge and the deviation in state of health. Thus, the covariance expresses a degree of correlation between the deviation in state of charge and the deviation in state of health. The statistical distance measure accounting for the statistical covariance between the deviation in state of charge and the deviation in state of health has the effect that comparatively large deviations in state of charge and/or in state of health from the collective state of charge or the collective state of health, respectively, may not be regarded as an anomaly as long as the respective deviations can be explained by a correlation of the state of charge and the state of health. However, even small deviations in state of charge and/or state of health from the collective state of charge or the collective state of health, respectively, may be regarded as an anomaly as soon as even small deviations cannot be explained by a correlation of the state of charge and the state of health. Thus, applying a statistical distance measure accounting for a covariance between the deviation in state of charge and the deviation in state of health is a way of specifically tailoring the statistical distance measure to naturally occurring deviations in state of charge and deviations in state of health. Consequently, an occurrence of an anomaly may be learned to the data model in a reliable manner.

In an example, the statistical distance measure is a Mahalanobis-type distance. A kind of a Mahalanobis-type distance is the Mahalanobis distance. When calculating the Mahalanobis distance for a specific battery cell, the data indicative of a deviation of the state of charge of the specific battery cell from the collective state of charge of the subset of battery cells is a first entry of a column vector *̅x̅*̅. The data indicative of a deviation of the state of health of the specific battery cell from the collective state of health of the subset of battery cells is a second entry of the column vector *x̅.* The Mahalanobis distance *d_{M}* is provided for the specific battery cell by the formula ${d}_{M} = \sqrt{{\vec{x}}^{T} {S}^{- 1} \vec{x}}$, wherein *S*⁻¹ is the inverse of the commonly known covariance matrix. The covariance matrix is calculated from a matrix having the deviations of the states of charges of all battery cells of the traction battery pack in the first column and the deviations of the states of health of all battery cells of the traction battery pack in the second column. Other Mahalanobis-type distances include the Bregman Divergence and the principal component analysis (PCA).

In another example, singular value decomposition may be used to derive a statistical distance measure per battery cell of the subset of battery cells. Singular values obtained from singular value decomposition may be interpreted as encoding a magnitude of a semiaxis of an ellipsoid encapsulating data points having coordinates being based on the first data and based on the second data. Singular vectors obtained from singular value decomposition may be interpreted as encoding a direction of the semiaxis of the ellipsoid encapsulating data points having coordinates being based on the first data and based on the second data.

In an example, the first statistical parameter is a measure of central tendency. Additionally or alternatively, the second statistical parameter is a measure of central tendency. In an example, the first statistical parameter is a mean value, a median or a mode. Similarly, the second statistical parameter may be a mean value, a median or a mode. The first statistical parameter being a measure of central tendency of the states of charge of the battery cells of the set of battery cells has the effect that the deviation in state of charge of a subset of battery cells, e.g. a single battery cell, is determined in relation to a statistically representative measure of the state of charge of its corresponding set of battery cells. The second statistical parameter being a measure of a central tendency of the states of health of the battery cells of the set of battery cells has the effect that the deviation in state of health of a subset of battery cells ,e.g. a single battery cell, is determined in relation to a statistically representative measure of the state of health of its corresponding set of battery cells. Both of this makes the resulting statistical distance measure particularly robust and reliable because outliers of the battery cells in terms of state of charge and/or state of health may not significantly influence the first statistical parameter and/or the second statistical parameter.

In an example, the state of charge is relatable to a ratio between an amount of electrical energy currently stored in a battery cell and a maximum amount of electrical energy storable in the battery cell. In other words, the state of charge is associable to a ratio between an amount of electrical energy currently stored in a battery cell and a maximum amount of electrical energy storable in the battery cell. In an example, the state of charge may be related or associated to a ratio between an amount of electrical energy currently stored in a battery cell and a maximum amount of electrical energy storable in the battery cell. In this context, the maximum amount of electrical energy storable in the battery cell is an amount of electrical energy that can actually be stored in the battery cell under practical conditions. The state of charge may typically be indicated by a percentage between 0 and 100%. Thus, the state of charge provides a realistic indication of how much of an actual energy storing capacitance of a battery cell is currently being used.

In an example, the state of health is described by one or more of
- a capacitance of the associated battery cell,
- an internal electrical resistance of the associated battery cell,
- a voltage providable by the associated battery cell,
- a self-discharge indicator of the associated battery cell,
- an indicator of an ability of the associated battery cell to accept a charge,
- a number of charging cycles of the associated battery cell,
- a number of discharging cycles of the associated battery cell,
- an age of the associated battery cell,
- a temperature of the associated battery cell,
- a total energy with which the associated battery cell is chargeable, and
- a total energy dischargeable from the associated battery cell.

The state of health of the battery cell may be a maximum amount of electric energy storable in the battery cell relative to a nominal amount of electric energy storable in the battery cell. The nominal amount of electric energy storable in the battery cell is an amount that is usually only reached under ideal conditions and when the battery cell has not been subject to any aging, yet. In particular, the state of health may also be described by a ratio of current maximum charging capacity of the battery cell to its original maximum charging capacity. Due to the fact that it may be difficult to determine a true state of health of a battery cell, the above-mentioned indicators may be used to describe the state of health of the battery cell. The above-mentioned indicators may be determined in a simple and reliable manner. Thus, a reliable indication of a state of health of a battery cell may be provided with simple but accurate means.

In an example, the subset of battery cells and/or the set of battery cells forms part of the same module of the traction battery pack. This means that all battery cells of the subset of battery cells or of the set of battery cells may be comprised in the same module of the traction battery pack. The set or subset of battery cells may comprise some battery cells of the same module of the traction battery pack or all battery cells of the same module of the traction battery pack. A module of the traction battery pack may be a subdivision of the traction battery pack. The module of the traction battery pack may be electrically connected in a way that the module forms a separate unit of the traction battery pack, i.e. the module may be charged and/or discharged separately from other modules of the traction battery pack and/or may be disconnectable from the remaining traction battery pack when other modules of the remaining traction battery pack are being charged and/or discharged. Also, all battery cells of a module of the traction battery pack may be charged and/or discharged at the same time. Thus, assessing an anomaly in one or more battery cells in respect of other battery cells from the same module of the traction battery pack provides a meaningful comparative group of battery cells. This enables the fourth data to provide an accurate indication of an anomaly being present in a battery cell of traction battery pack for a vehicle as will be explained in more details further below.

In an example, the first data may not comprise the deviation in state of health, the deviation in state of charge and the statistical distance measure for each battery cell of the traction battery pack. Instead, the first data may only comprise a maximum deviation in state of health, a maximum deviation in state of charge and a maximum statistical distance measure per subset of battery cells of the traction battery pack or even only per traction battery pack. This reduces an amount of data that needs to be considered during training, which increases training speed and facilitates data storage. At the same time, it has been observed that a high accuracy of the trained data model in detecting anomalous traction battery packs can be maintained even though not all available data on the deviation in state of health, the deviation in state of charge and the statistical distance measure per battery cell is used for training.

In an example, the first data indicative of a state parameter of the traction battery pack takes into account cell balancing of battery cells of the traction battery pack. Cell balancing is a technique that may be applied by a battery management system when charging or discharging the traction battery pack. Cell balancing may take account of deviating states of health and/or deviating states of charge among the battery cells of the traction battery pack. To this end, particularly when the traction battery pack is not currently being used, electric energy may be discharged from battery cells of a higher state of charge, e.g. through a resistor, in order to reach a state of charge similar to less charged battery cells. This may be referred to as passive cell balancing. Cell balancing may also refer to cases, when the traction battery pack is being charged, some battery cells may be provided with a higher amount of electric energy than others or may be provided with electric energy for a longer period of time than others in order to achieve a uniform state of charge of the battery cells of the traction battery pack during charging or at least at the end of charging. When the traction battery pack is being discharged, some battery cells may be subject to a higher amount of electric energy withdrawal than others or electric energy may be withdrawn for a longer period of time from some battery cells than from others in order to achieve a uniform state of charge of the battery cells of the traction battery pack during discharging or at least at an end of discharging, i.e. in a state in which all usable electric energy in the traction battery pack is used up. Also, a more active cell balancing is conceivable, particularly when the traction battery pack is not currently being used. In the more active cell balancing, electric energy from battery cells having a comparatively high state of charge is provided to battery cells within the traction battery pack having a comparatively low state of charge in order to even out states of charge of the battery cells of the traction battery pack. In simplified words, cell balancing may shift electric charges among the battery cells of the traction battery pack to maintain a comparatively uniform state of charge over all battery cells of the traction battery or at least over a subset of battery cells of the traction battery. Accounting for cell balancing in the first data means correcting the obtained state of charge of each battery cell by an amount of cell balancing, i.e. an amount of shifted energy or a time period of cell balancing, applied to each battery cell. This way, it is possible to calculate a true state of charge of a battery cell that it would exhibit if no cell balancing was applied. This has the effect that anomalies in the battery cells of the traction battery pack do not get covered up due to cell balancing. Instead, the data model may learn from patterns in the training data that would otherwise be hidden to the data model if cell balancing was not accounted for.

In an example, the second data is indicative of at least one of:
- an average state of charge of the traction battery pack,
- an average charging power applied during charging of the traction battery pack,
- an average ambient temperature of an environment that the traction battery pack is exposed to,
- average temperature of traction battery pack,
- an amount of discharge energy of the traction battery pack per time unit, and
- an amount of battery cell balancing applied to battery cells of the traction battery pack.

Any average mentioned in the list above relates to a time period over which the respective average parameter is determined. The time period may cover a fixed time period, e.g. a month or a year, or may relate to the time period since production of the vehicle and or of the traction battery pack. An average may relate to a mean of a respective parameter over measurements taken at a plurality of points in time. The average or mean may relate to a geometrical mean, a median or some kind of weighted average. In more detail, the average state of charge of the traction battery pack is indicative of an average state of charge of all battery cells of the traction battery pack over the time period. The average charging power applied during charging of the traction battery pack relates to an average charging power that has been applied to the traction battery pack during all charging cycles within the time period. The average ambient temperature of an environment that the traction battery pack is exposed to characterizes an average ambient temperature of the vehicle which the traction battery pack is comprised in over the time period. The average temperature of the traction battery pack characterizes a temperature of the traction battery pack, measured e.g. in an interior of the traction battery pack and/or at an outer surface of the traction battery pack, over the time period. The amount of discharge energy and the amount of battery cell balancing relates to a total aggregate of discharge energy or cell balancing over the time period. The discharge energy is the amount of electric energy that has been withdrawn from the traction battery pack during the time period. This parameter is often easier to determine than an electric energy that has been provided to the traction battery pack, e.g. by charging at a stationary charging station or by regenerative braking. However, the amount of electric energy withdrawn from the traction battery pack is closely related to the amount of electric energy provided to the traction battery pack during charging and may therefore be indicative of similar anomalies of the traction battery pack. The amount of battery cell balancing applied to battery cells of the traction battery pack may relate to an amount of cell balancing applied to some battery cells of the traction battery pack, i.e. to a subset, or to all battery cells of the traction battery pack. The amount of battery cell balancing may be determined from a total amount of electric energy that is shifted between the battery cells due to cell balancing or from an amount of time cell balancing is applied to the traction battery pack. Considering the above parameters as second data indicative of a usage history statistic of the traction battery pack helps the data model in learning what ranges of first data may be expected under which circumstances of use of the traction battery pack. On the one hand, this has the effect that the data model may be trained to detect even small deviations from an optimum in the first data as anomaly in case the circumstances of use of the traction battery pack are optimal, e.g. cool average temperature of the traction battery pack (e.g. 5°C to 10°C) or low amount of discharge energy of the traction battery pack. On the other hand, this has the effect that the data model may be trained to accept even larger deviations from an optimum in the first data as properly functioning traction battery pack in case the circumstances of use of the traction battery pack are suboptimal, e.g. high ever temperature of the traction battery pack (e.g. above 10°C) or intense use indicated by a high amount of discharge energy of the traction battery pack per time unit.

In an example, the method further comprises obtaining third data indicative of metadata of the traction battery pack. The third data relate to a plurality of traction battery packs of vehicles out of the group of vehicles. Moreover, the third data are labelled with labelling data indicative of a presence or absence of an anomaly of the associated traction battery pack. Additionally, the example of the method comprises further training the data model based on the labelled third data.

More specifically, the third data relate to the same or at least parts of the vehicles of the group of vehicles that the first data and the second data relate to. Thus, the third data are labelled with the same labeling data as the first data and the second data. Consequently, the labelled first data, the labelled second data and additionally the labelled third data may be referred to as training data. Having the data model trained on the labelled third data has the effect that further structures and/or patterns in the training data may be learned, i.e. uncovered, by the data model that would have remained hidden without considering the labelled third data in the training of the data model.

In an example, the third data is indicative of at least one of:
- a country in which the vehicle comprising the traction battery pack is and/or was operated,
- a vehicle type of the vehicle comprising the traction battery pack,
- a manufacturing plant of the traction battery pack and/or of the vehicle comprising the traction battery pack,
- a production line of battery cells of the traction battery pack,
- a production date of battery cells of the traction battery pack,
- a type of separator used in battery cells of the traction battery pack,
- a type of cell chemistry used in battery cells of the traction battery pack.

The country in which the vehicle comprising the traction battery pack is and/or was operated relates to countries or areas in which the vehicle has been operated over the time period detailed above. This has the effect that a climate of a country or area in which the vehicle has been operated may be taken into account when training the data model. The vehicle type of the vehicle comprising the traction battery may, for example, comprise vehicle types of a compact class vehicle, a sedan vehicle, a sports utility vehicle (SUV), a truck and/or a lorry. Considering the vehicle type may give an indication of a weight of a vehicle that the traction battery pack powers and, thus, may roughly indicate a strain that the traction battery pack is under when powering and/or driving the vehicle. Considering a manufacturing plant of the traction battery pack and/or of the vehicle may allow uncovering production habits that occur in a particular manufacturing plant that frequently lead to anomalies in traction battery packs. The same applies to considering a production line of battery cells of the traction battery pack only that a level of granularity is finer when considering specific production lines compared to only considering a whole manufacturing plant. Taking into account production dates of battery cells of the battery pack help narrowing down time periods during which faulty battery cells have been produced that later lead to anomalies in traction battery packs in which the faulty battery cells have been used. A separator is a sheet of material that electrically separates an anode from a cathode of a battery cell of the traction battery pack. Depending on the type of separator used in a battery cell, i.e. a specific material, thickness and/or folding or rolling state, anomalies in traction battery packs may be more or less frequent. The type of cell chemistry used in battery cells of the traction battery pack indicates a chemistry of the anode and/or of the cathode of battery cells used in the traction battery pack, e.g. LCO, LMO, NMC, NCA, LFP or LMFP as cathode chemistries and e.g. C, SCC or LTO as anode chemistries. Considering the type of chemistries of the anode and of the cathode as well as combinations thereof may enable the data model to extract cell chemistries that are more prone to exhibiting an anomaly than other cell chemistries. All in all, considering the above types of meta data as third data in the training of the data model allows the data model to not only rely on current or historical traction battery pack state parameters. Instead, the data model may apply weights to deviations in the first data and to deviations in the second data that are based on the third data indicative of metadata of the traction battery pack. This way, training effort may be enhanced and an accuracy in providing decisions and/or predictions on anomalies of traction battery packs may be increased.

In an example, the method further comprises performing an outlier removal technique on the first data, on the second data, and/or on the third data. Removing outliers generally enhances the overall performance by improving model accuracy, reducing the risk of the model being biased and decreases time to convergence, hence reduces use of resources during training. The outlier removal technique may be applied to the labelled first data, to the labelled second data and/or to the labelled third data. In particular, the outlier removal technique is applied before training of the data model. Thus, it may be said that the training data is cleared from implausible data items of the first data, of the second data and/or of the third data by applying the outlier removal technique. This has the effect that the data model may not be confused during training by invalid data items of the first data, of the second data and/or of the third data. Invalid data items may for example be created due to faulty determining means for the first data and/or for the second data and/or by transmission errors occurring between the vehicle comprising the traction battery pack and a data processing apparatus on which the method is executed. Moreover, entries in a data storage indicative of metadata of the traction battery pack may be wrong, e.g. due to human errors. Training the data model only on plausible first data, second data and/or third data avoids implausible decision rules to be learned to the data model.

In an example, the outlier removal technique comprises performing a plausibility check between at least two of:
- the state parameter of the traction battery pack,
- the usage history statistic of the traction battery pack, and
- the metadata of the traction battery pack.

In other words, the plausibility check may involve data items that are of at least two of the first data, the second data and the third data. In an example, a data tuple of first data, second data and third data may be deemed implausible if metadata indicative of a country in which the vehicle is being operated does not match second data indicative of an average ambient temperature of an environment that the traction battery pack is exposed to. In another example, a data tuple of first data, second data and third data may be deemed implausible if first data indicative of a maximum Mahalanobis distance of battery cells of a traction battery pack is comparatively low but second data indicative of an amount of battery so balancing apply to the battery cells of the traction battery pack is comparatively high. Excluding such implausible data tuples from the training data again has the effect that it is avoided that implausible decision rules are learned to the data model. This effect is even leveraged as different types of data, i.e. the first data, the second data and/or the third data, are combined when making the plausibility check.

In an example, the method further comprises oversampling of one or more data items of the first data, the second data, and/or the third data that have a label indicating a presence of an anomaly of a traction battery pack. Oversampling is to be understood in the sense of data augmentation. This means that synthetic data of the type of the first data, of the second data and/or of the third data is created from data items of the first data, of the second data and/or of the third data that have actually been determined from the real world by determining means. The synthetic data is not actually determined from the real world, but is created by applying plausibility models and/or variance models that generate artificial output data that shows a similar pattern as actually determined input data from the real world. In an example, the oversampling technique used comprises the synthetic minority oversampling technique (SMOTE). Using this technique, additional data items of the first data, of the second data and/or of the third data are generated that comprise a label indicating a presence of an anomaly in a traction battery pack. This has the effect that training data being indicative of anomalous traction battery packs, which is usually scarce, is manifolded. Thus, the data model may be trained to achieve a higher accuracy in detecting anomalous traction battery packs. It is noted that when applying an oversampling technique, especially the synthetic minority oversampling technique, a data model is more likely to overfit to the training data. Thus, it may be advantageous to apply ensemble learning in order to mitigate a risk for overfitting of the data model to the training data.

According to a second aspect, there is provided a method for detecting an anomaly in a traction battery pack of a vehicle. The method comprises:
- obtaining first data indicative of at least one state parameter of the traction battery pack,
- obtaining second data indicative of a usage history statistic of the traction battery pack, and
- inferring fourth data indicative of an anomaly of the traction battery based on a trained data model and based on the obtained first data and based on the obtained second data, in particular wherein the trained data model is trained according to the method of the first aspect.

An anomaly in a traction battery pack may be understood as a deviation from a norm and/or from an expected state of the traction battery pack. This may affect a performance of the traction battery pack, e.g. an electric performance. A data model is understood as a representation or at least approximation of data structures or data patterns in a decision or prediction function. Obtaining the first data and the second data is to be understood as receiving or determining the first data and the second data. The first data indicative of at least one state parameter of the traction battery pack data that characterizes a state of the traction battery pack, i.e. a property associated with a point in time. The first data can be imagined as a snapshot of a state of the traction battery pack taken at a specific point in time. The first data does not comprise any aggregation and/or clustering of data over time. Still, the first data may comprise not only one but a plurality of data items relating to a specific point in time. The plurality of data items may relate to different state parameters of the traction battery pack at a specific point in time and/or to the same state parameter of the traction battery pack at different points in time. It is noted that the time of determining the first data does not necessarily have to be the same as the time of receiving the first data, especially in the case in which obtaining the first data is understood as receiving the first data. The second data indicative of a usage history statistic of the traction battery pack comprises an aggregation and/or processing of a plurality of characterizations of historic states of the traction battery pack. Historic states of the traction battery pack are understood as a plurality of states that the traction battery pack has assumed prior to the determination of the second data or up to the determination of the second data. This means that historic states are states from a past time. The aggregation and/or processing of a plurality of characterizations of historic states of the traction battery pack may for example comprise an accumulation, an averaging and/or a normalization of traction battery pack state parameters from a plurality of points in time.

It is understood that, preferably, the first data and the second data are obtained from a different vehicle and/or a traction battery pack than those that have been used for training the data model, preferably according to the method of the first aspect. At least, it is understood that the first data and the second data are obtained at a different, preferably at a later, point in time than the first data and the second data that has been used for training the data model. In the present method for detecting an anomaly in a traction battery pack of the vehicle, the fourth data is the output, i.e. the decision and/or prediction, of the data model based on the first data and based on the second data. In other words, the fourth data is the determination that the trained data model makes based on first data and second data as input data of a traction battery pack that is under investigation if it exhibits an anomaly. Due to the consideration of the first data, the second data and due to the use of the trained data model the fourth data is highly accurate.

In an example, the method further comprises, if the fourth data is indicative of a presence of an anomaly of the traction battery pack, identifying one or more battery cells of the traction battery pack that exhibit an anomaly. The identification is based on one or more of:
- a deviation of a state of charge per subset of battery cells of the traction battery pack from a first statistical parameter, the first statistical parameter being descriptive of a collective state of charge for a set of battery cells to which the subset belongs,
- a deviation of a state of health per subset of battery cells of the traction battery pack from a second statistical parameter, the second statistical parameter being descriptive of a collective state of health for a set of battery cells to which the subset belongs, and
- a statistical distance measure per subset of battery cells of the traction battery pack based on the deviation of the state of charge and the deviation of the state of health.

The same definitions of the deviation of the state of charge, of the first statistical parameter, of the deviation of the state of health, of the second statistical parameter and of the statistical distance measure as provided above in relation to the method of the first aspect also apply to the present method of the second aspect. Similarly, the same considerations on considering cell balancing as provided above in relation to the method of the first aspect also apply to the present method of the second aspect. As before, the consideration of cell balancing is an option. Thus, the present method of the second aspect may optionally take into account cell balancing of battery cells of the traction battery pack that is being investigated by the trained data model if it exhibits an anomaly or if it functions properly.

A defective battery cell of the traction battery pack may be identified based on a predefined threshold for the deviation in state of charge, the deviation in state of health and/or for the statistical distance measure. In a particular example in which the Mahalanobis distance of a battery cell exceeds a predefined statistical distance threshold, the respective battery cell can reliably be identified as comprising an anomaly.

In an example, the method may further comprise obtaining third data indicative of metadata of the traction battery pack and further inferring the fourth data based on the trained data model and based on the third data. The same considerations on the type of the third data as explained above in relation to the method of the first aspect also apply to the present method of the present second aspect. This has the effect that both a detection accuracy of anomalous traction battery packs and a detection accuracy of properly functioning traction battery packs may be enhanced.

According to a third aspect, there is provided a method for handling an anomaly in a traction battery pack of a vehicle. The method comprises:
- detecting an anomaly in a traction battery pack of a vehicle using the method of the second aspect,
- providing a maintenance indicator for a vehicle whose traction battery pack is detected to exhibit an anomaly, and/or causing an anomaly mitigation action for the traction battery pack of the vehicle whose traction battery pack exhibits an anomaly.

The maintenance indicator may comprise an indicator flagging an anomalous traction battery pack in a database. This has the particular effect that owners of vehicles having anomalous traction battery packs may be informed, e.g. by mail, by email or by phone, to have their vehicle undergo maintenance in a workshop. Additionally or alternatively, the maintenance indicator may comprise a signal that may be sent to the vehicle that comprises the anomalous traction battery pack. The signal may be visualized in an interior of the vehicle by means of a control lamp or on a screen in order to make a user of the vehicle aware of its anomalous traction battery pack. In response thereto, the user of the vehicle may adapt his or her style of driving to a more conservative and less sporty style of driving in order to prevent further damage to the traction battery pack. The anomaly mitigation action may refer to performing specific, e.g. predefined, actions by the method of the third aspect in order to prevent further damage to the traction battery pack and/or to the vehicle comprising the traction battery pack.

In an example, the anomaly mitigation action comprises at least one of:
- driving the vehicle at a reduced driving power and/or at a reduced speed,
- stopping the vehicle,
- driving the vehicle autonomously to a workshop,
- booking a maintenance service at a workshop,
- updating a database of the anomalous traction battery pack.

Driving the vehicle at a reduced driving power and/or reduced speed, in particular at a reduced maximum speed has the effect that an electric power withdrawn from the traction battery pack of the vehicle is reduced. Thus, a strain that is exercised on the traction battery pack is minimized, which may prevent further damage to the traction battery pack and/or to the vehicle or which may increase a remaining driving range of the vehicle up to a full breakdown of the traction battery pack. The vehicle may be driven at a reduced driving power and/or at a reduced speed by a user of the vehicle or the vehicle may opt for a reduced driving power and/or for a reduced speed by itself. Stopping the vehicle may be regarded as an emergency measure to prevent imminent damage to the traction battery pack and/or to the vehicle. This may be considered as a measure of last resort in case the detected anomaly is that serious that it would not be advisable to continue driving the vehicle. Again, stopping the vehicle may be accomplished by a user of the vehicle or by the vehicle itself. If the vehicle is an autonomously driven vehicle, the vehicle may be made to drive autonomously to a workshop in order to have the traction battery pack of the vehicle undergo maintenance. In an example, the user and/or the owner of the vehicle may be asked for permission, e.g. via a screen in the interior of the vehicle if the user and/or the owner is sitting inside the vehicle or via a smart phone app if the user and/or the owner is at a distance from the vehicle, to have his or her vehicle autonomously drive to the workshop. It is understood that also a user of the vehicle may drive his or her vehicle to the workshop. As a further anomaly mitigation action, the method of the third aspect may inform a workshop of an incoming vehicle that comprises a traction battery pack that exhibits an anomaly. This may be done via a booking of a maintenance service at the workshop. Of course, if the vehicle is an autonomous vehicle, the vehicle may be made to drive autonomously to the workshop at a time to reach the workshop at a predetermined time of the booked maintenance service. The anomaly mitigation action comprising updating a database may comprise updating a database of a specific type of traction battery pack that has exhibited an anomaly. In particular a database comprising metadata of the traction battery pack may be updated of the anomaly that a particular traction battery pack has shown. Additionally or alternatively, a database of vehicles comprising anomalous traction battery packs may be updated in case the traction battery pack of a particular vehicle has successfully undergone maintenance. Thereby the number of vehicles, and which vehicles comprise traction battery packs that suffer from an anomaly and that still need to undergo maintenance, can be tracked.

The method of the first aspect, the method of the second aspect and/or the method of the third aspect may be at least partly computer-implemented, and may be implemented in software or in hardware, or in software and hardware. Further, the methods may be carried out by computer program instructions running on means that provide data processing functions. The data processing means may be a suitable computing means, such as an electronic control module etc., which may also be a distributed computer system. The data processing means or the computer, respectively, may comprise one or more of a processor, a memory, a data interface, or the like.

According to a fourth aspect, there is provided a data processing apparatus comprising means for carrying out the method of the first aspect, the method of the second aspect and/or the method of the third aspect. Providing such a data processing apparatus has the effect that a data model may be trained based on labelled first data and based on labelled second data wherein labeling data is indicative of the presence or absence of an anomaly of the associated traction battery pack. Additionally or alternatively, such a data processing apparatus allows detecting an anomaly in a traction battery pack of a vehicle, in particular by using the trained data model. Further additionally or alternatively, an anomaly in a traction battery pack of a vehicle may be efficiently handled, i.e. a maintenance indicator for a vehicle comprising anomalous traction battery pack may be provided and/or anomaly mitigation action may be caused by the data processing apparatus. It is noted that the data processing apparatus may be comprised in an external server, i.e. a server external from a vehicle. In this case, training the data model based on data from traction battery packs of a plurality of vehicles of a group of vehicles is facilitated. Moreover, if the data processing apparatus is comprised in an external server, monitoring of traction batteries of a plurality of vehicles of a group of vehicles is enabled. It is further noted that the data processing apparatus for executing the method of the first aspect may be comprised in a different external server than the data processing apparatus for executing the method of the second aspect and the method of the third aspect. It is also conceivable that the data processing apparatus for executing the method of the second aspect and the method of the third aspect may be comprised in an individual vehicle. In this case, monitoring of the traction battery pack of the individual vehicle if it is anomalous or not is enabled.

According to a fifth aspect, there is provided a computer program comprising instructions which, when the computer program is executed by a computer, cause the computer to carry out the method of the first aspect, the method of the second aspect and/or the method of the third aspect. Providing such a computer program has the effect that a data model may be trained based on labelled first data and based on labelled second data wherein labeling data is indicative of the presence or absence of an anomaly of the associated traction battery pack. Additionally or alternatively, such a computer program allows detecting an anomaly in a traction battery pack of a vehicle, in particular by using the trained data model. Further additionally or alternatively, an anomaly in a traction battery pack of a vehicle may be efficiently handled, i.e. a maintenance indicator for a vehicle comprising anomalous traction battery pack may be provided and/or anomaly mitigation action may be caused by the computer program.

According to a sixth aspect, there is provided a computer-readable storage medium comprising instructions which, when executed by a computer, cause the computer to carry out the method of the first aspect, the method of the second aspect and/or the method of the third aspect. Providing such a computer-readable storage medium has the effect that a data model may be trained based on labelled first data and based on labelled second data wherein labeling data is indicative of the presence or absence of an anomaly of the associated traction battery pack. Additionally or alternatively, such a computer-readable storage medium allows detecting an anomaly in a traction battery pack of a vehicle, in particular by using the trained data model. Further additionally or alternatively, an anomaly in a traction battery pack of a vehicle may be efficiently handled, i.e. a maintenance indicator for a vehicle comprising anomalous traction battery pack may be provided and/or anomaly mitigation action may be caused by instructions stored on the computer-readable storage medium.

According to a seventh aspect, there is provided a use of first data indicative of at least one state parameter and second data indicative of a usage history statistic of a traction battery pack of a vehicle for detecting an anomaly in the traction battery pack of the vehicle. Using a combination of the first data indicative of at least one state parameter of the traction battery pack and second data indicative of a usage history statistic of a traction battery pack of a vehicle allows efficiently training a data model in order to make it configured to determine an anomaly in a traction battery pack of a vehicle. Additionally or alternatively, a data model, preferably the trained data model, may take a combination of first data and second data of a traction battery pack of a vehicle that has not been used for training as an input in order to provide an output of fourth data indicative of an anomaly of the traction battery of the vehicle. Additionally or alternatively, a data model, preferably the trained data model, may take a combination of first data and second data of a traction battery pack of a vehicle, which has been determined at a time different from a time of determining the first data and second data used for training the data model, as an input in order to provide an output of fourth data indicative of an anomaly of a traction battery of a vehicle.

In an example, the use may further comprise using third data indicative of metadata of the traction battery pack of the vehicle for detecting an anomaly in the traction battery pack of the vehicle. This has the effect that both a detection accuracy of anomalous traction battery packs and a detection accuracy of properly functioning traction battery packs may be enhanced.

It should be noted that the above examples may be combined with each other irrespective of the aspect involved.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a system for detecting an anomaly in a traction battery pack of a vehicle, the system comprising a vehicle having a data storage being communicatively connected to a cloud server, wherein the cloud server comprises a data processing apparatus according to the present disclosure comprising means for executing a method according to the present disclosure for handling an anomaly in a traction battery pack of a vehicle and for executing a method according to the present disclosure for detecting an anomaly in a traction battery pack of a vehicle,
- Figure 2: shows an alternative configuration of the system for detecting an anomaly in a traction battery pack of a vehicle of Figure 1, wherein the data processing apparatus is communicatively connected to a data storage that is external to the vehicle,
- Figure 3: shows a bar chart of example states of charge of all battery cells of a traction battery pack of the vehicle of the system of Figure 1,
- Figure 4: shows a bar chart of example states of health of all battery cells of the traction battery pack of the vehicle of the system of Figure 1,
- Figure 5: shows a diagram representing deviations in state of charge from a first statistical parameter and deviations in state of health from a second statistical parameter of the battery cells of the traction battery pack of the vehicle of the system of Figure 1, wherein each point in the diagram is associated with one battery cell, wherein a first vector indicates a direction of largest variance in the data, and wherein a second vector perpendicular thereto is shown,
- Figure 6: shows a diagram representing deviations in state of charge from a first statistical parameter and deviations in state of health from a second statistical parameter of the battery cells of the traction battery pack of the vehicle of the system of Figure 1, wherein again each point in the diagram is associated with one battery cell, and wherein the first vector and the second vector have been normalized,
- Figure 7: shows a group of vehicles, each communicatively connected to a cloud server, wherein the cloud server comprises a data processing apparatus according to the present disclosure comprising means for executing a method according to the present disclosure for training a data model for detecting an anomaly in a traction battery pack of a vehicle,
- Figure 8: shows a diagram of first data indicative of a maximum Mahalanobis distance per traction battery pack over second data indicative of an average ambient temperature of an environment that a traction battery pack is exposed to for vehicles of the group of vehicles of Figure 7,
- Figure 9: shows steps of the method according to the present disclosure for handling an anomaly in a traction battery pack of a vehicle and steps of the method according to the present disclosure for detecting an anomaly in a traction battery pack of a vehicle, and
- Figure 10: shows steps of the method according to the present disclosure for training a data model for detecting an anomaly in a traction battery pack of a vehicle.

### DETAILED DESCRIPTION

The Figures are merely schematic representations and serve only to illustrate examples of the disclosure. Identical or equivalent elements are in principle provided with the same reference signs.

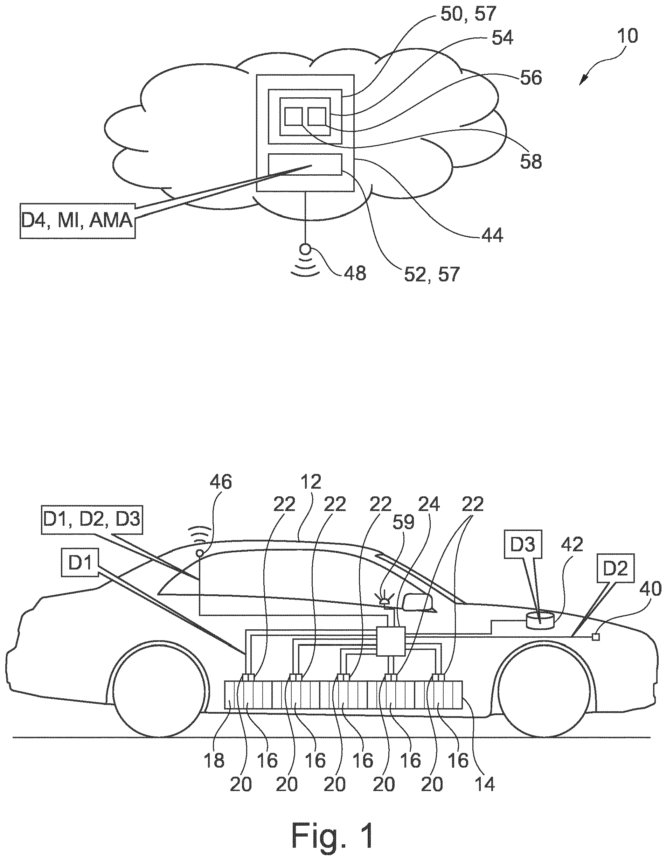

Figure 1 shows a system 10 for detecting an anomaly in a traction battery pack 14 of a vehicle 12.

The system 10 comprises a vehicle 12.

In the present example, the vehicle 12 is a battery electric vehicle 12. Thus, the vehicle 12 comprises a traction battery pack 14.

The traction battery pack 14 comprises five battery modules 16 of battery cells 18. The battery modules 16 may also be referred to as sets of battery cells 18 of the traction battery pack 14.

Each battery module 16 comprises twenty battery cells 18. For the ease of representation, only five battery cells 18 per battery module 16 are shown in Figure 1 and only one of the battery cells 18 is equipped with a reference sign.

Each battery module 16 comprises means 20 for determining a state of charge of its battery cells 18. Each battery module 16 further comprises means 22 for determining a state of health of its battery cells 18.

Moreover, a deviation dSoC of a state of charge of an individual battery cell 18 from a collective state of charge of the battery module 16 that the respective battery cell 18 is part of may be determined from the determined states of charge of the battery cells 18. Also, a deviation dSoH of a state of health of an individual battery cell 18 from a collective state of health of the battery module 16 that the respective battery cell 18 is part of may be determined from the determined states of health of the battery cells 18.

Furthermore, a statistical distance measure being indicative of a covariance between the deviation dSoC of a state of charge and the deviation dSoH of a state of health of the battery cells 18 may be derived.

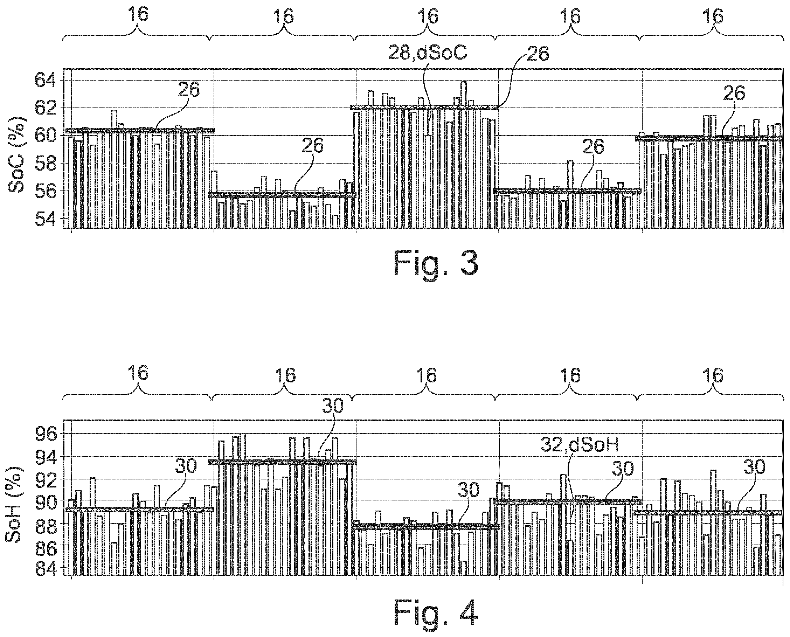

The vehicle 12 comprises a first data processing apparatus 24 configured to carry out a method for determining said parameters from the determined states of charge and determined states of health of the battery cells 18 of the traction battery pack 14. This method is also referred to as a first method. A detailed explanation for determining the deviation dSoC of a state of charge, the deviation dSoH of a state of health and the statistical distance measure is provided in the following with reference to Figures 3 to 6.

States of charge of all battery cells 18 of all battery modules 16 of the traction battery pack 14 of the vehicle 12 of Figure 1 are shown in the bar chart in Figure 3.

In this context, the state of charge is a ratio between an amount of electrical energy currently stored in a battery cell 18 and a maximum amount of electrical energy storable in the battery cell 18 under practical conditions. Practical conditions may particularly involve that the battery cell 18 has already been subject to an aging process, which reduces the maximum amount of electrical energy storable in the battery cell 18.

The collective state of charge of a battery module 16 may be a mean and/or a median of the states of charge of the battery cells 18 of a battery module 16. In the present case, the median 26 state of charge per battery module 14 is determined and represented in the bar chart of Figure 3 as a horizontal line spanning over all bars associated with battery cells 18 of a battery module 16.

A deviation dSoC in state of charge of each battery cell 18 from the determined collective state of charge, i.e. the median 26 state of charge, per battery module 16 is the difference between the median 26 and the state of charge of an individual battery cell 18 (median minus state of charge).

The first method is executed on the first data processing apparatus 24 of the vehicle 12 and further determines a maximum deviation in a state of charge from the median state of charge over all battery cells 18 of the entire traction battery pack 14. The maximum deviation in state of charge is indicated in Figure 3 by reference sign 28.

States of health of all battery cells 18 of all battery modules 16 of the traction battery pack 14 of the vehicle 12 of Figure 1 are shown in the bar chart in Figure 4.

In this context, the state of health is a ratio between a current maximum amount of electrical energy storable in an aged battery cell 18 and the maximum amount of electrical energy storable in a new battery cell 18. The maximum amount of electrical energy storable in a new battery cell 18 is often referred to as a nominal capacitance of a battery cell 18.

Since it is difficult to directly measure a true state of health of a battery cell 18, the means 22 for detecting a state of health may determine one or more of the following parameters of the battery cell 18 to indicate its state of health:
- a capacitance of the associated battery cell 18,
- an internal electrical resistance of the associated battery cell 18,
- a voltage providable by the associated battery cell 18,
- a self-discharge indicator of the associated battery cell 18,
- an indicator of an ability of the associated battery cell 18 to accept a charge,
- a number of charging cycles of the associated battery cell 18,
- a number of discharging cycles of the associated battery cell 18,
- an age of the associated battery cell 18,
- a temperature of the associated battery cell 18,
- a total energy with which the associated battery 18 cell is chargeable, and
- a total energy dischargeable from the associated battery cell 18.

The collective state of charge of a battery module 16 may be a mean and/or a median of the states of health of the battery cells 18. In the present case, the median 30 state of health per battery module 16 is determined and represented in the bar chart of Figure 4 as a horizontal line spanning over all bars associated with battery cells 18 of a battery module 16.

A deviation dSoH in state of health of each battery cell 18 from the determined collective state of health, i.e. the median 30 state of health, per battery module 16 is the difference between the median 30 and the state of health of an individual battery cell 18 (median minus state of health).

The first method is executed on the first data processing apparatus 24 of the vehicle 12 and further determines a maximum deviation in state of health from the median state of health over all battery cells 18 of the traction battery pack 14. This maximum deviation in state of health is indicated in Figure 4 by reference sign 32.

The statistical distance measure used herein accounts for a statistical covariance between a deviation dSoC of the state of charge per battery cell 16 from the median 26 state of charge of a battery module 16 and a deviation dSoH of the state of health per battery cell 18 from the median 30 state of health of the battery module 14. The statistical distance measure is also determined by executing the first method on the first data processing apparatus 24 of the vehicle 12.

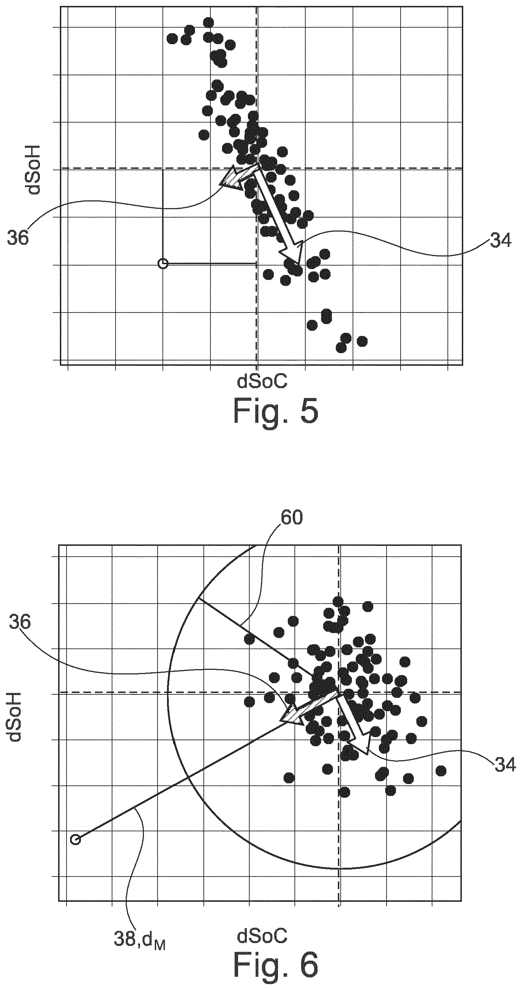

In Figure 5, the deviations dSoC of the state of charge and the deviations dSoH of the state of health are graphically illustrated for each of the battery cells 18.

In the present example, the statistical distance measure is a Mahalanobis distance *d_{M}.*

In the present case, the Mahalanobis distance *d_{M}* is calculated for each battery cell 18 of the traction battery pack 14. The deviation dSoC of the state of charge of a specific battery cell 18 from the median 26 state of charge of the battery module 16 forms a first entry of a column vector *̅x̅*̅. The deviation dSoH of the state of health of the specific battery cell 18 from the median 30 state of health of the battery module 16 forms a second entry of the column vector *̅x̅*̅.

The Mahalanobis distance *d_{M}* for each battery cell 18 is provided by the formula ${d}_{M} = \sqrt{{\vec{x}}^{T} {S}^{- 1} \vec{x}}$*,* wherein *S*⁻¹ is the inverse of the commonly known covariance matrix. The covariance matrix is calculated from a matrix having the deviations dSoC of states of charge of all battery cells 18 of the traction battery pack 14 in a first column and the deviations dSoH of states of health of all battery cells 18 of the traction battery pack 14 in a second column. This results in an inverse *S*⁻¹ of the covariance matrix being in the dimension of 2x2. In conjunction with the dimension of *x̅^{T}* being 1x2 and the dimension of *̅x̅*̅ being 2x1, this results in a scalar 1x1 value for the Mahalanobis distance *d_{M}* of an individual battery cell 18.

For an even better understanding, the mathematical considerations from above will be explained in a graphic manner with respect to Figures 5 and 6.

In Figure 5, the deviation dSoC in state of charge of a battery cell 18 is represented on the x-axis and the deviation dSoH in state of health of a battery cell 18 is represented on the y-axis. Each data point in the diagram of Figure 5 corresponds to one battery cell 18 of the traction battery pack 14 of the vehicle of Figure 1. The location of each data point in the diagram of Figure 5 is defined by the deviation dSoC in state of charge and the deviation dSoH in state of health of the corresponding battery cell 18 from the median 26 state of charge and from the median 30 state of health of the battery module 16 comprising the corresponding battery cell 18, respectively.

In general, it can be observed in the diagram of Figure 5 that the deviation dSoC in state of charge and the deviation dSoH in state of health of the battery cells 18 of the traction battery pack 14 show a negative covariance.

A first vector 34 pointing to the bottom right of the diagram indicates a direction of largest variance in the data. A second vector 36 points in a direction perpendicular to the first vector 34. A magnitude of the first vector 34 and a magnitude of the second vector 36 indicate a standard deviation in the data along a direction of the first vector 34 and along a direction of the second vector 36, respectively.

Figure 6 shows in principle the same type of diagram as in Figure 5. However, the x-axis indicating a deviation dSoC in state of charge and the y-axis indicating a deviation dSoH in state of health have been linearly transformed such that the first vector 34 and the second vector 36 are normalized. This means that a length of the first vector 34 and a length of the second vector 36 equals one unit length.

The Mahalanobis distance *d_{M}* of a battery cell 18 is the distance of the data point corresponding to the battery cell 18 from the origin of the diagram shown in Figure 6. A maximum Mahalanobis distance *d_{M}* 38 of the battery cells 18 of the traction battery pack 14 is the maximum of the distances of the data points from the origin of the diagram shown in Figure 6. In the diagram in Figure 6, the maximum Mahalanobis distance *d_{M}* 38 is associated with the data point on the bottom left.

The maximum deviation 28 of a state of charge, the maximum deviation 32 of a state of health and the maximum Mahalanobis distance *d_{M}* 38 are indicative of a state parameter of the traction battery pack 14. Thus, these parameters may be referred to as first data D1 indicative of a state parameter of the traction battery pack 14 of the vehicle 12 of Figure 1.

Coming back to Figure 1, the vehicle 12 further comprises an ambient temperature sensor 40 for determining a temperature of an environment that the vehicle 12 and therefore also its traction battery pack 14 is exposed to. An ambient temperature of an environment that the traction battery pack 14 is exposed to and especially an average of the ambient temperature of an environment that the traction battery pack 14 is exposed to may be referred to as second data D2 indicative of a usage history statistic of the traction battery pack 14.

A further example of second data D2 indicative of a usage history statistic of the traction battery pack 14 may comprise data indicative of an average charging power applied during charging of the traction battery pack 14. To acquire this data, the vehicle 12 may further comprise a charging power sensor for determining a charging power that the vehicle 12 is provided with while its traction battery pack 14 is being charged. It is noted that in this context, charging may refer to charging the traction battery pack 14 at a stationary charging station connected to an electricity grid or to charging the traction battery pack 14 by means of regenerative braking.

Another example of second data D2 indicative of a usage history statistic of the traction battery pack 14 may comprise data indicative of a yearly amount of discharge energy of the traction battery pack 14. To acquire this data, the vehicle 12 may further comprise voltage and current sensors for determining a voltage and a current that is withdrawn from the traction battery pack 14.

Another example of second data D2 indicative of a usage history statistic of the traction battery pack 14 may comprise data indicative of an amount of battery cell balancing applied to the battery cells 18 of the traction battery pack 14. Battery cell balancing is a strategy during charging and/or discharging of the traction battery pack 14 to keep individual battery cells 18 of the entire traction battery pack 14 or at least of a module 16 of the traction battery pack 14 at substantially the same state of charge even though the individual battery cells 18 may exhibit different states of health. For this purpose, the vehicle 12 may further comprise a battery management system. The battery management system may provide second data D2 indicative of the cell balancing applied to each battery cell 18 of the traction battery pack 14 during charging and/or discharging of the traction battery pack 14. It is noted that the amount of cell balancing may be positive or negative for each battery cell 18 depending on whether electric energy was provided to (or at least not discharged from) the battery cell 18 or discharged from the battery cell 18 due to cell balancing. Thus, a corrected state of charge of each individual battery cell 18 that takes account of cell balancing may be obtained by correcting a state of charge determined by the means 20 for determining a state of charge by the amount of cell balancing applied to each individual battery cell 18.

The vehicle 12 of Figure 1 further comprises a data storage 42 for storing third data D3 indicative of metadata of the vehicle's traction battery pack 14.

Metadata of the vehicle's traction battery pack 14 may comprise data indicative of a country in which the vehicle 12 is and/or was operated. This data may be obtained from a global positioning antenna that may further be comprised in the vehicle 12. The metadata of the vehicle's traction battery pack 14 may further comprise a vehicle type, a manufacturing plant of the traction battery pack 14 and/or of the vehicle 12, a production line of battery cells 18 of the traction battery pack 14, a production time of battery cells 18 of the traction battery pack 14, and/or a type of separator/cell chemistry used in battery cells 18 of the traction battery pack 14. This data may for example be programmed and stored in the data storage 42 of the vehicle 12 at the time of completion of production of the vehicle 12 in the manufacturing plant.

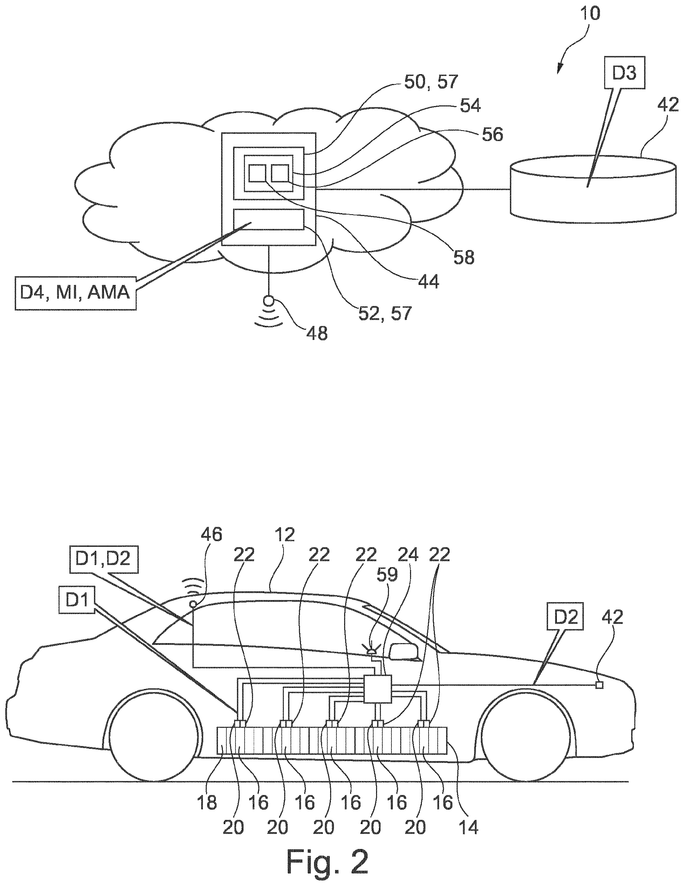

Figure 2 shows an alternative configuration of the system 10 for detecting an anomaly in a traction battery pack 14 of a vehicle 12. In this alternative configuration, the data storage 42 for storing third data D3 indicative of metadata of the vehicle's traction battery pack 14 is a central data storage 42, i.e. a database, that is communicatively connected to a second data processing apparatus 44 on an external cloud server, which will be explained in the following. Third data D3 indicative of metadata of the traction battery pack 14 of a plurality of vehicles 12 may be stored in the central data storage 42 instead of storing the metadata in a data storage 42 that is comprised in a vehicle 12.

Coming back to Figure 1, the vehicle 12 further comprises a communication interface 46.

In the present example, the communication interface 46 comprises a communication antenna compatible with mobile communication services such as 5G, LTE, GSM and/or a satellite internet connection.

The communication interface 46 serves the vehicle 12 to send the first data D1 indicative of a state parameter of the traction battery pack 14, the second data D2 indicative of a usage history statistic of the traction battery pack 14 and the third data D3 indicative of metadata of the traction battery pack 14 to the second data processing apparatus 44.

The system 10 further comprises the second data processing apparatus 44 on the external cloud server.

The second data processing apparatus 44 is communicatively connected to the vehicle 12 by the vehicle's communication interface 46 and the mobile communication service. To this end, the second data processing apparatus 44 comprises a communication interface 48 compatible with the respective mobile communication service. Thus, the second data processing apparatus 44 is configured to receive the first data D1, second data D2 and third data D3 sent by the vehicle 12, which may be located at a large distance from the external cloud server. This way, first data D1, second data D2 and third data D3 of the traction battery pack 14 of the vehicle 12 may be collected at the second data processing apparatus 44 while the vehicle 12 is driving in an environment at a distance to the second data processing apparatus 44 anywhere around the world.

In alternative configurations, it is conceivable that the second data processing apparatus 44 is communicatively connected to the vehicle's communication interface 46 via Bluetooth, Wi-Fi, a local area network, a CAN-bus system and/or another wired connection. In these alternative configurations, the communication interfaces 46, 48 of the vehicle 12 and of the second data processing apparatus 44 are understood to be compatible with these alternative connection protocols. In this alternative configuration, the first data D1, the second data D2 and the third data D3 may particularly be collected at the second data processing apparatus 44 from the vehicle 12 while the vehicle 12 undergoes maintenance in a stationary workshop.

In a further alternative configuration, it is conceivable that the second data processing apparatus 44 is comprised in the vehicle 12. Thus, the second data processing apparatus 44 may be directly provided with first data D1, second data D2 and third data D3 of the traction battery pack 14 of the vehicle 12. Thus, the second data processing apparatus 44 may be comprised in the first data processing apparatus 24.

The second data processing apparatus 44 comprises data storage unit 50 and a data processing unit 50.

The data storage unit 50 comprises a computer-readable storage medium 54.

On the computer-readable storage medium 54, there is provided a trained data model 56 and a computer program 58.

In the present example, the trained data model 56 comprises a supervised learning model.

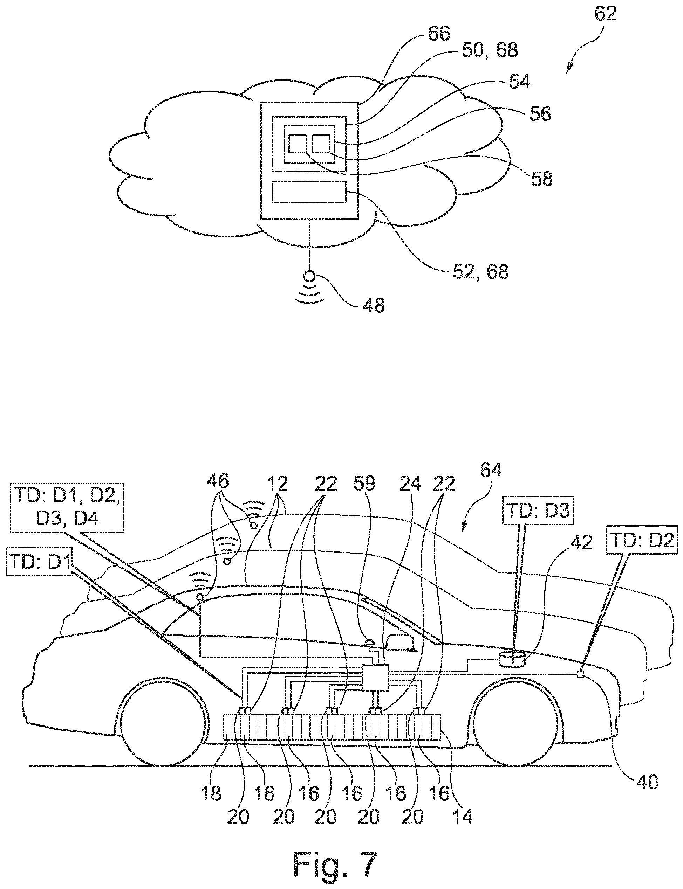

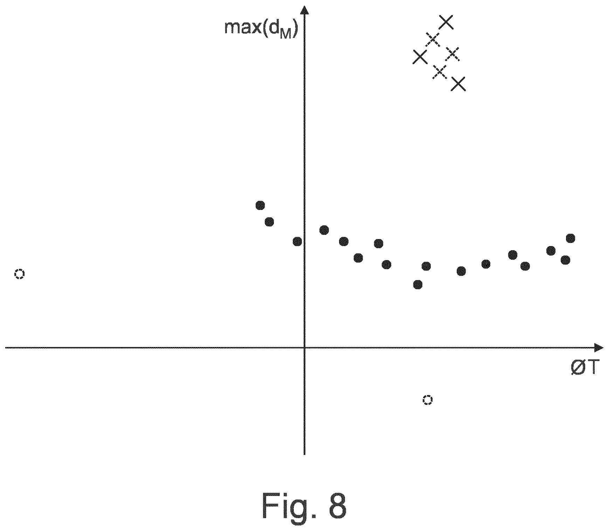

In more detail, the trained data model 56 comprises a random forest data model 56 trained to provide fourth data D4 indicative of an anomaly of the traction battery pack 14 of the vehicle 12 based on the received first data D1, second data D2 and third data D3. The random forest data model 56 has been trained using training data TD that is of the same type as the first data D1, the second data D2 and the third data D3. However, the training data TD is different from the first data D1, the second data D2 and the third data D3 in terms of individual values of individual data points. Training of the random forest data model 56 will be explained further below with reference to Figures 7 and 8.

The computer program 58 and, thus, also the computer-readable storage medium 54, comprise instructions which, when executed by the data processing unit 52, or, more generally speaking, a computer, cause the computer or the data processing unit 52 to carry out a method for handling an anomaly in a traction battery pack 14 of a vehicle 12. This method may also be referred to as a second method.

Consequently, the data storage unit 50 and the data processing unit 52 form means 57 for carrying out the second method.

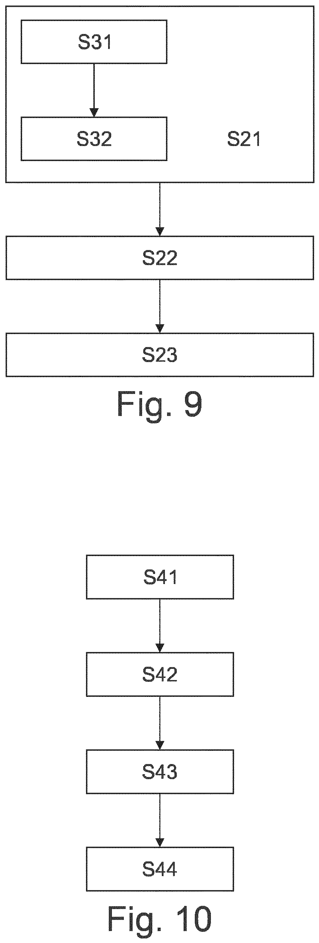

Steps of the second method are schematically illustrated in Figure 9.

In a first step S21 of the second method executed on the second data processing apparatus 44, a method for detecting an anomaly in a traction battery pack 14 of a vehicle 12 is executed. This method may be referred to as a third method. Thus, the data storage unit 50 and the data processing unit 52 form means 57 for carrying out the third method.

In a step S31 of the third method, first data D1, second data D2 and third data D3 of the traction battery pack 14 of the vehicle 12 is obtained at the second data processing apparatus 44.

In the present example, the first data D1 indicative of a state parameter of the traction battery pack 14 of the vehicle 12 that is obtained at the second data processing apparatus 44 comprises the above-explained maximum deviation 28 of a state of charge of the battery cells 18 of the traction battery pack 14. This parameter is of a value of 2% for the vehicle 12 of Figure 1.

Moreover, the first data D1 indicative of a state parameter of the traction battery pack 14 of the vehicle 12 that is obtained at the second data processing apparatus 44 comprises the above-explained maximum deviation 32 of a state of health of the battery cells 18 of the traction battery pack 14. This parameter is of a value of 3.5% for the vehicle 12 of Figure 1.

Furthermore, the above-explained maximum Mahalanobis distance *d_{M}* 38 of the battery cells 18 of the traction battery pack 14 of the vehicle 12 is obtained as first data D1 indicative of a state parameter of the traction battery pack 14 of the vehicle 12 at the second data processing apparatus 44. The maximum Mahalanobis distance *d_{M}* 38 of the battery cells 18 of the traction battery pack 14 of the vehicle 12 of Figure 1 is 5.5.

Beyond that, the above-explained average ambient temperature of the environment that the traction battery pack 14 is exposed to is received as second data D2 indicative of a usage history statistic of the traction battery pack 14 at the second data processing apparatus 44 in the first step of the third method (S31). It is assumed that the value of this parameter is 7°C for the vehicle 12 of Figure 1.

Finally, the country in which the vehicle 12 is operated is received as third data D3 indicative of metadata of the traction battery pack 14 at the second data processing apparatus 44 in the first step of the third method (S31). Here, it is assumed that the country in which the vehicle 12 of Figure 1 is operated is Sweden.

In a second step S32 of the third method executed on the second data processing apparatus 44, fourth data D4 indicative of an anomaly of the traction battery 14 of the vehicle 12 is provided by the trained random forest data model 56 based on the received first data D1, second data D2 and third data D3. In other words, the fourth data D4 of the traction battery pack 14 of the vehicle 12 is a function of the first data D1, the second data D2 and of the third data D3. The function is provided by the trained random forest data model 56. Further in other words, the trained random forest data model 56 takes the first data D1, the second data D2 and the third data D3 as input in order to provide the fourth data D4 indicative of an anomaly of the traction battery pack 14 as a predictive output.

The fourth data D4 indicative of an anomaly of the traction battery pack 14 may be positive or negative. Positive fourth data D4 indicate that the traction battery pack 14 of the vehicle 12 exhibits an anomaly and needs to undergo maintenance or needs to be replaced in order to prevent further damage to the traction battery pack 14 and/or to the vehicle 12. Negative fourth data D4 means that the traction battery pack 14 of the vehicle 12 does not exhibit an anomaly and therefore does not need to undergo maintenance, i.e. the traction battery pack 14 is deemed to function properly.

In the present example, the trained random forest data model 56 decides that the traction battery pack 14 of the vehicle 12 needs to undergo maintenance as the maximum Mahalanobis distance *d_{M}* 38 of 5.5 appears as too high given the rather optimal operating condition of the traction battery pack 14 in a cool environment of an average ambient temperature of 7°C (not freezing cold <5°C, not hot > 10°C).

In a consecutive second step S22 of the second method executed on the second data processing apparatus 44, a maintenance indicator MI is created and sent to the vehicle 12. At the vehicle 12, the maintenance indicator MI triggers a visual indicator 59 in an interior of the vehicle 12 such that an occupant thereof may be made aware of a maintenance need of the anomalous traction battery pack 14. An occupant of the vehicle 12 may acknowledge the visual indicator 59, e.g. by pressing an acknowledgement button or a respective field on a touch screen.

However, in the present example, the vehicle 12 is not being used at the time of execution of the second method. Therefore, no occupant is inside the vehicle 12 who could acknowledge the visual indicator 59 indicating an anomaly of the traction battery pack 14. In fact, the vehicle 12 is not being used because its owner is on a business trip abroad.

Hence, a consecutive third step S23 of the second method executed on the second data processing apparatus 44 is triggered. The third step S23 comprises causing an anomaly mitigation action for the traction battery pack 14 of the vehicle 12.

In the present example, the vehicle 12 is an autonomously driving vehicle 12. Causing the anomaly mitigation action comprises requesting permission from the owner of the vehicle 12 to have the vehicle 12 drive autonomously to a workshop in order to perform the required maintenance of the traction battery pack 14. The request may be provided to the owner of the vehicle 12 through an app of the manufacturer of the vehicle 12 that the owner has installed on his or her smartphone.

In the present example, the owner of the vehicle 12 grants the request for having the vehicle 12 drive autonomously to a workshop because he or she will not need the vehicle 12 for another week due to the business trip abroad that the owner needs to complete anyway.

Consequently, the vehicle 12 is triggered to drive autonomously to a workshop. Maintenance personnel at the workshop may assume from the visual indicator 59 displayed in the interior of the vehicle 12 that the traction battery pack 14 of the vehicle 12 requires maintenance. Additionally, the visual indicator 59 may indicate to which extent the traction battery pack 14 needs maintenance and which component thereof (entire traction battery pack 14, specific battery module 16, specific battery cell 18) needs to undergo maintenance.

For example, it may be indicated to maintenance personnel at the workshop that a specific battery cell 18 needs to be replaced. The specific battery cell 18 may be identified based on its Mahalanobis distance *d_{M}* exceeding a predefined threshold 60 (see Fig. 6).

After completion of the maintenance of the traction battery pack 14, which may involve replacing defective battery cells 18, defective battery modules 16 or even the entire traction battery pack 14, the vehicle 12 drives back to the area where it was parked when it received the request to drive autonomously to the workshop. This way, the owner of the vehicle 12 has a vehicle 12 with a traction battery pack 14 that is in good health at his or her disposal when he or she will be back from the business trip. Further damage to the traction battery pack 14 and/or the vehicle 12 has been prevented without the owner of the vehicle 12 sacrificing time on driving the vehicle 12 to and fetching it from the workshop.

In the following, training of the above-introduced data model 56 will be explained with reference to Figures 7 and 8.

Figure 7 shows a system 62 for training a data model for detecting an anomaly in a traction battery pack 14 of a vehicle 12.

The system 62 comprises a group 64 of vehicles 12. The group 64 of vehicles 12 may also be referred to as a vehicle fleet.

For ease of representation, only three vehicles 12 are shown as a representative of the group 64 of vehicles 12. Of course, it is understood that the group 64 of vehicles 12 may also comprise any number of vehicles 12 other than three.

In a particular example, the group 64 of vehicles 12 may comprise more than 10,000 vehicles 12.

The vehicles 12 of the group 56 of vehicles 12 are identical to the vehicle 12 of Figure 1 with respect to the features explained above in relation thereto.

As explained above, the vehicle 12 of Figure 1 comprises a data storage 42 for providing third data D3 indicative of metadata of the vehicle's traction battery pack 14. It is understood that the vehicles 12 of the group 64 of vehicles 12 of Figure 7 may, in an alternative, not comprise a data storage 42 (like the vehicle shown in Figure 2). In this case, a central data storage 42 storing third data indicative of metadata of the traction batteries 14 of the vehicles 12 of the group 64 of vehicles 12 may be communicatively connected to a third data processing apparatus 66 on an external server, which will be explained in the following.

The system 62 further comprises the third data processing apparatus 66 on the external server.

In the present case, the third data processing apparatus 66 is the same as the second data processing apparatus 44 explained above. Thus, the data model 56 is trained on the same data processing apparatus 44, 66 as on which it is used for making predictions anomalies of traction batteries 14 of vehicles 12. Hence, the features explained above in relation to the second data processing apparatus 44 also apply to the third data processing apparatus 66 discussed in the following.

However, the third data processing apparatus 66 may, in an alternative, also be different from the second data processing apparatus 44. Thus, the data model 56 may be trained on a different data processing apparatus than on which it is applied for making predictions on anomalies of traction batteries 14 of vehicles 12.

Beyond the features explained above in relation to the second data processing apparatus 44, the computer program 58 and, thus, also the computer-readable storage medium 54, comprise instructions which, when executed by the data processing unit 52, or, more generally speaking, a computer, cause the computer or the data processing unit 52 to carry out a fourth method for training a data model 56 for detecting an anomaly in a traction battery pack 14 of a vehicle 12.

Consequently, the data storage unit 50 and the data processing unit 52 form means 68 for carrying out the fourth method.

Steps of the fourth method are schematically illustrated in Figure 10.

In a first step S41 of the fourth method executed on the third data processing apparatus 66, first data D1 indicative of a state parameter of the traction battery pack 14 of each vehicle 12 of the vehicle fleet 64 is obtained by the third data processing apparatus 66. In the present example, the first data D1 comprises the above-explained maximum deviation 28 of a state of charge of battery cells 18 of the traction battery pack 14 for each vehicle 12 of the vehicle fleet 64. The first data D1 also comprises the above-explained maximum deviation 32 of a state of health of battery cells 18 of the traction battery pack 14 for each vehicle 12 of the group 64 of vehicles 12. Furthermore, the first data D1 comprises the above-explained maximum Mahalanobis distance *d_{M}* 38 of the battery cells 18 of the traction battery pack 14 for each vehicle 12 of the group 64 of vehicles 12.

Still in the first step S41 of the fourth method, second data D2 indicative of a usage history statistic of the traction battery pack 14 of each vehicle 12 of the group 64 of vehicles 12 is obtained by the third data 66 processing apparatus. In the present example, this comprises data on an average ambient temperature of an environment that the traction battery pack 14 of each vehicle 12 of the group 64 of vehicles 12 is exposed to.

Moreover, in the first step S41 of the fourth method, third data D3 indicative of metadata of the traction battery pack 14 of each vehicle 12 of the group 64 of vehicles 12 is obtained by the third data processing apparatus 66. In the present example, this comprises data on a country in which each of the vehicles 12 of the group 64 of vehicles 12 is operated.

Furthermore, in the first step S41 of the fourth method, data on a presence or an absence of an anomaly the traction battery pack 14 of each of the vehicles 12 of the group 64 of vehicles is obtained by the third data processing apparatus 66.

The data on an anomaly of the traction battery pack 14 of a vehicle 12 of the group 64 of vehicles 12 may be obtained from a field study. This means that a large number of vehicles 12 that are in service with their owner are monitored. Some vehicle's traction batteries 14 suffer from a fault and/or a breakdown during a period of conduction of the field study. Thus, the first data D1, the second data D2 and the third data D3 obtained from these some vehicles 12 is labelled with a positive fourth data D4 indicative of an anomaly of its traction battery packs 14. Other vehicle's traction batteries 14 may not encounter a fault and or a breakdown, i.e. function properly, during the period of conduction of the field study. Thus, the first data D1, the second data D2 and the third data D3 obtained from these other vehicles 12 is labelled with a negative fourth data indicative of an anomaly of its traction battery packs 14.

In an alternative, the fourth data D4 on an anomaly of the traction battery pack 14 of a vehicle 12 of the group 64 of vehicles 12 may be obtained from regular checks and/or maintenance that vehicles 12 need to undergo in a workshop. If a fault of a traction battery pack 14 of a vehicle 12 is detected during a regular check and or a regular maintenance in a workshop, the first data D1, the second data D2 and the third data D3 that has been received from the vehicle 12 at the third data processing apparatus 66 is labelled with a positive fourth data D4 indicative of an anomaly of its traction battery pack 14. If a traction battery pack 14 of the vehicle 12 is determined to function properly during a regular check or a regular maintenance in a workshop, the first data D1, the second data D2 and the third data D3 of this vehicle 12 that has been received at the third data processing apparatus 66 is labelled with a negative fourth data D4 indicative of an anomaly of its traction battery pack 14.

In a further alternative, the fourth data D4 on an anomaly of the traction battery pack 14 of a vehicle 12 of the group 64 of vehicles 12 may be obtained from occasions in which the owner and/or a customer has brought the vehicle 12 to a workshop because he or she has noticed a fault in the traction battery pack 14 of his or her vehicle 12. In this case, the first data D1, the second data D2 and the third data D3 of this vehicle 12 received at the third data processing apparatus 66 is labelled with a positive fourth data D4 indicative of an anomaly of its traction battery pack 14.

It is understood that the three outlined alternatives of generating fourth data D4 indicative of an anomaly of a traction battery pack 14 of a vehicle 12 may also be combined with one another or all of three alternatives may be applied in a combined manner in order to generate a sizable amount of fourth data D4 indicative of an anomaly of traction batteries 14 of vehicles 12 of the group 64 of vehicles 12.

Figure 8 shows a diagram of data points corresponding to traction batteries 14 of vehicles 12 of the group 64 of vehicles 12. On the x-axis, second data D2 indicative of an average ambient temperature of an environment that the traction batteries 14 of the vehicles 12 of the group 64 of vehicles 12 are exposed to is provided. On the y-axis, first data D1 indicative of a maximum Mahalanobis *d_{M}* 38 distance of battery cells 18 of the traction batteries 14 of the vehicles 12 of the group 64 of vehicles is provided.

It is observable that there is an optimum average temperature range in which the maximum Mahalanobis distance *d_{M}* 38 is minimal. It has been observed that the optimum average temperature range is between 5°C and 10°C. In regimes of below 5°C average ambient temperature and above 10°C average ambient temperature, a strain on the traction battery pack 14 due to increased thermal conditioning requirements (heating below 5°C average ambient temperature, cooling above 10°C average ambient temperature) is elevated. This causes greater wear of battery cells 18 of traction batteries 14 exposed to these temperature regimes, which is reflected in the first data D1 as increased maximum Mahalanobis distances *d_{M}* 38 of these traction batteries 14.

However, this is a natural condition, which is not due to faulty traction batteries 14. Thus, these data points are labelled with a negative fourth data D4. These data points are indicated by filled dots in Figure 8.

In Figure 8, it is also observable that there is a data point of negative maximum Mahalanobis distance *d_{M}.* Moreover, it is observable that there is a further data point in a far negative average ambient temperature regime. These data points are indicated by a dotted circle.

In a second step S42 of the fourth method executed on the third data processing apparatus 66, outlier data points are excluded from the labelled data by means of plausibility checks.

Applied to the present example, the data point showing the negative maximum Mahalanobis distance *d_{M}* is excluded because the Mahalanobis distance *d_{M}* can only assume nonnegative values. Moreover, a plausibility check on the corresponding third data of the data point in the far negative average ambient temperature regime has revealed that the corresponding vehicle 12 is operated in the country of Portugal. An average ambient temperature that the traction battery pack 14 of a vehicle 12 operated in that country is expected to be around 15°C. Due to an implausibility of the provided data point on the average ambient temperature and the country in which the corresponding vehicle 12 is operated, also the data point in the far negative average ambient temperature regime is excluded for the further procedure of training the data model 56.

In Figure 8, three further data points are observable that exhibit a comparatively high maximum Mahalanobis distance *d_{M}* although those data points are assigned to the optimum ambient temperature regime. These data points are indicated by an "X" having solid lines. These data points correspond to traction batteries 14 of vehicles 12 that have been identified as faulty. In other words, these data points are labelled with a positive fourth data D4.

It is observable that the number of data points corresponding to vehicles 12 having a faulty traction battery pack 14 is significantly lower than the number of data points that correspond to vehicles 12 having a properly functioning traction battery pack 14.

In order to enhance a training result of the data model 56, the data points corresponding to the vehicles 12 having a faulty traction battery pack 14 are oversampled. This means that artificial data points having similar properties are artificially added to the data set shown in Figure 8. In Figure 8, these data points are indicated by an "X" having dotted lines. In an example, the Synthetic Minority Oversampling Technique (SMOTE) may be applied for such oversampling.

Summing up the steps of the third method explained so far, the labelled data points of the data set as generated in step S41 and as shown in Figure 8 are cleared from implausible data points in step S42. The data points of the remaining data showing a positive fourth data D4 are oversampled in step S43. The resulting data set may be referred to as training data TD.

The training data TD comprises first data D1, second data D2 and third data D3, all labelled with fourth data D4 of the corresponding traction batteries 14. Moreover, an increased amount of data points being labelled with a positive fourth data D4 is present in the training data TD than in the not yet oversampled first data D1, second data D2 and third data D3.

The data model 56 is trained using a method of supervised learning.

Since the training data TD comprises oversampled data ("X's" having dotted lines in Figure 8), which naturally shows a high similarity to preexisting data points ("X's" having solid lines in Figure 8), this increases a risk for a trainable data model 56 to overfit to the training data TD and lose its ability to generalize on unknown data.

Thus, in the present example, an ensemble learning model, more specifically a random forest data model 56, is used as a data model 56 to be trained. A random forest data model 56 has been observed to be less prone to overfitting to training data TD that comprises data points of high similarity due to oversampling. Hence, by choosing a random forest data model 56 to be trained using the training data TD maintains an ability of the data model 56 to generalize on data of the same type as the training data TD but that the data model 56 has not seen during training.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. A computer program may be stored/distributed on a suitable medium such as an optical storage medium or a solid-state medium supplied together with or as part of other hardware, but may also be distributed in other forms, such as via the Internet or other wired or wireless telecommunication systems. Any reference signs in the claims should not be construed as limiting the scope of the claims.

### LIST OF REFERENCE SIGNS

- 10: system for detecting an anomaly in a traction battery pack of a vehicle
- 12: vehicle
- 14: traction battery pack
- 16: battery module
- 18: battery cell
- 20: means for determining a state of charge
- 22: means for determining a state of health
- 24: first data processing apparatus
- 26: median state of charge per battery module
- 28: maximum deviation in state of charge
- 30: median state of health per battery module
- 32: maximum deviation in state of health
- 34: first vector
- 36: second vector
- 38: maximum Mahalanobis distance
- 40: ambient temperature sensor
- 42: data storage
- 44: second data processing apparatus
- 46: communication interface of vehicle
- 48: communication interface of second/third data processing apparatus
- 50: data storage unit
- 52: data processing unit
- 54: computer-readable storage medium
- 56: data model
- 57: means for carrying out second and third method
- 58: computer program
- 59: visual indicator
- 60: predefined threshold of Mahalanobis distance
- 62: system for training a data model for detecting an anomaly in a traction battery pack of a vehicle
- 64: group of vehicles
- 66: third data processing apparatus
- 68: means for carrying out fourth method

- AMA: anomaly mitigation action
- *d_{M}*: Mahalanobis distance
- dSoC: deviation of state of charge
- dSoH: deviation of state of health
- D1: first data
- D2: second data
- D3: third data
- D4: fourth data
- MI: maintenance indicator
- TD: training data

- S21: first step of second method
- S22: second step of second method
- S23: third step of second method
- S31: first step of third method
- S32: second step of third method
- S41: first step of fourth method
- S42: second step of fourth method
- S43: third step of fourth method
- S44: fourth step of fourth method

## Claims

1. A method for training a data model (56) for detecting an anomaly in a traction battery pack (14) of a vehicle (12), the method comprising:
- obtaining first data (D 1) indicative of at least one state parameter of the traction battery pack (14) and second data (D2) indicative of a usage history statistic of the traction battery pack (14),
wherein the first data (D1) and the second data (D2) relate to a plurality of traction battery packs (14) of vehicles (12) out of a group (64) of vehicles (12), and
wherein the first data (D1) and the second data (D2) are labelled with labelling data indicative of a presence or absence of an anomaly of the associated traction battery pack (14),
- training the data model (56) based on the labelled first data (D1) and the labelled second data (D2).

2. The method of claim 1, wherein the data model (56) comprises a supervised learning model.

3. The method of claim 1 or 2, wherein the data model (56) comprises a random forest classification model.

4. The method of any of the preceding claims, wherein the first data (D1) is indicative of at least one of:
- a deviation (dSoC) of a state of charge per subset of battery cells (18) of the traction battery pack (14) from a first statistical parameter, the first statistical parameter being descriptive of a collective state of charge for a set of battery cells (18) to which the subset belongs,
- a deviation (dSoC) of a state of health per subset of battery cells (18) of the traction battery pack (14) from a second statistical parameter, the second statistical parameter being descriptive of a collective state of health for a set of battery cells (18) to which the subset belongs, and
- a statistical distance measure per subset of battery cells (18) of the traction battery pack (14) based on the deviation (dSoC) of the state of charge and the deviation (dSoH) of the state of health.

5. The method of any of the preceding claims, wherein the first data (D1) takes into account cell balancing of battery cells (18) of the traction battery pack (14).

6. The method of any of the preceding claims, wherein the second data (D2) is indicative of at least one of:
- an average state of charge of the traction battery pack (14),
- an average charging power applied during charging of the traction battery pack (14),
- an average ambient temperature of an environment that the traction battery pack (14) is exposed to,
- average temperature of traction battery pack (14),
- an amount of discharge energy of the traction battery pack (14) per time unit, and
- an amount of battery cell balancing applied to battery cells (18) of the traction battery pack (14).

7. The method of any one of the preceding claims, further comprising:
- obtaining third data (D3) indicative of metadata of the traction battery pack (14), wherein the third data (D3) relate to a plurality of traction battery packs (14) of vehicles (14) out of the group (64) of vehicles (12),
wherein the third data (D3) are labelled with labelling data indicative of a presence or absence of an anomaly of the associated traction battery pack (14), and
- further training the data model (56) based on the labelled third data (D3).

8. The method of claim 7, wherein the third data (D3) is indicative of at least one of:
- a country in which the vehicle (12) comprising the traction battery pack (14) is and/or was operated,
- a vehicle type of the vehicle (12) comprising the traction battery pack (14),
- a manufacturing plant of the traction battery pack (14) and/or of the vehicle (12) comprising the traction battery pack (14),
- a production line of battery cells (18) of the traction battery pack (14),
- a production date of battery cells (18) of the traction battery pack (14),
- a type of separator used in battery cells (18) of the traction battery pack (14),
- a type of cell chemistry used in battery cells (18) of the traction battery pack (14).

9. The method of any of the preceding claims, further comprising performing an outlier removal technique on the first data (D1), on the second data (D2), and/or on the third data (D3).

10. The method of claim 9, wherein the outlier removal technique comprises performing a plausibility check between at least two of:
- the state parameter of the traction battery pack (14),
- the usage history statistic of the traction battery pack (14), and
- the metadata of the traction battery pack (14).

11. The method of any one of the preceding claims, further comprising oversampling of one or more data items of the first data (D1), the second data (D2), and/or the third data (D3) that have a label indicating a presence of an anomaly of a traction battery pack (14).

12. A method for detecting an anomaly in a traction battery pack (14) of a vehicle (12), the method comprising:
- obtaining first data (D 1) indicative of at least one state parameter of the traction battery pack (14),
- obtaining second data (D2) indicative of a usage history statistic of the traction battery pack (14), and
- inferring fourth data (D4) indicative of an anomaly of the traction battery (14) based on a trained data model (56) and based on the obtained first data (D1) and based on the obtained second data (D2), in particular wherein the trained data model (56) is trained according to the method of any one of the preceding claims.

13. The method of claim 12, further comprising, if the fourth data (D4) is indicative of a presence of an anomaly of the traction battery pack (14), identifying one or more battery cells (18) of the traction battery pack (14) that exhibit an anomaly, wherein the identification is based on one or more of:
- a deviation (dSoC) of a state of charge per subset of battery cells (18) of the traction battery pack (14) from a first statistical parameter, the first statistical parameter being descriptive of a collective state of charge for a set of battery cells (18) to which the subset belongs,
- a deviation (dSoH) of a state of health per subset of battery cells (18) of the traction battery pack (14) from a second statistical parameter, the second statistical parameter being descriptive of a collective state of health for a set of battery cells (18) to which the subset belongs, and
- a statistical distance measure per subset of battery cells (18) of the traction battery pack (14) based on the deviation (dSoC) of the state of charge and the deviation (dSoH) of the state of health.

14. A method for handling an anomaly in a traction battery pack (14) of a vehicle (12), the method comprising:
- detecting an anomaly in a traction battery pack (14) of a vehicle (12) using the method of claim 12 or 13,
- providing a maintenance indicator (MI) for a vehicle (12) whose traction battery pack (14) is detected to exhibit an anomaly, and/or causing an anomaly mitigation action (AMA) for the traction battery pack (14) of the vehicle (12) whose traction battery pack (14) exhibits an anomaly.

15. The method of claim 14, wherein the anomaly mitigation action (AMA) comprises at least one of:
- driving the vehicle (12) at a reduced driving power and/or at a reduced speed,
- stopping the vehicle (12),
- driving the vehicle (12) autonomously to a workshop,
- booking a maintenance service at a workshop,
- updating a database of the anomalous traction battery pack (14).
